# EUROPÄISCHE PATENTANMELDUNG

(11) **EP 1 253 717 A2**
(43) Veröffentlichungstag der Anmeldung: **30.10.2002**
(21) Anmeldenummer: 02009405.8
(22) Anmeldetag: 25.04.2002
(51) Int. Cl.: H03K 17/96

(54) **Kapazitive Tastatur mit Auswerteschaltung**

(30) Priorität: 28.04.2001 DE 10121008
(71) Anmelder: RAWE ELECTRONIC GmbH, D-88171 Weiler (DE); Dyna Systems GmbH, 88161 Lindenberg (DE)
(72) Erfinder: Pfaff, Joachim, 87545 Burgberg (DE)
(74) Vertreter: Riebling, Peter, Dr.-Ing.

(57) **Zusammenfassung**

Die Erfindung betrifft also eine kapazitive Tastatur mit mindestens einer Auswerteschaltung, beinhaltend mindestens eine kapazitive Tastenfläche, welche mit der mindestens einen Auswerteschaltung elektrisch leitend verbunden ist und welche mindestens eine kapazitive Tastenfläche auf und/oder in einer Isolierplatte angeordnet ist, und welche mindestens eine kapazitive Tastenfläche durch Annäherung und/oder Berührung eines beweglichen Dielektrikums seine Kapazität verändert, welche Kapazitätsänderung in der Auswerteschaltung auswertbar ist, wobei die mindestens eine Tastenfläche mindestens zwei, voneinander elektrisch isolierte und elektrisch auf- und entladbare Kapazitätsflächen beinhaltet und deren jeweilige Ent- und/oder Aufladeströme durch die mindestens eine Auswerteschaltung derart ausgewertet werden können, dass mindestens zwischen einem Ruhezustand und einem beabsichtigten Schaltzustand der Tastenfläche unterschieden werden kann, wobei die mit den jeweiligen Kapazitätsflächen zusammenwirkenden Kapazitätsflächen des jeweiligen kapazitiven Schalters über das angenäherte und/oder kontaktierte bewegliche Dielektrikum mit der Auswerteschaltung elektrisch leitend verbunden ist. Vorteil hierbei ist, dass nicht die Entladung oder Aufladung einer einzigen Kapazität am Tastenfeld untersucht wird, sondern dass das Verhalten von mindestens zwei voneinander elektrisch isolierten Kapazitäten miteinander verglichen wird, wobei es offen bleibt, wie und wo diese Kapazitäten angeordnet sind. Hierdurch können gewollte Schaltvorgänge von unbeabsichtigten Schaltvorgängen und von Verschmutzungen etc. sicher unterschieden werden.

## Beschreibung

Die Erfindung betrifft eine kapazitive Tastatur mit Auswerteschaltung nach dem Oberbegriff des unabhängigen Patentanspruches.

Eine derartige kapazitive Tastatur ist beispielsweise mit dem Gegenstand der EP 0 691 743 B1 bekannt geworden. Bei dieser bekannten Tastatur wird mittels eines Generators die kapazitiv abgetastete Taste permanent umgeladen, um mittels eines Verstärkers eine mittlere Gleichspannung zu gewinnen. Bei der EP 0 691 743 B1 ist nur eine ungenaue Auswertung des an der kapazitiven Schaltfläche anliegenden Potentials möglich, weil Störungen auch die Integratorspannung des in der Schaltung enthaltenen Integrators erhöhen und hierdurch die Schaltschwelle unsicher wird. Für jede der dort angegebenen Tasten ist eine eigene Schaltung bestehend aus einem Verstärker und einem Integrator notwendig. Dies ist mit dem Nachteil verbunden, dass sich Temperaturänderungen unterschiedlich auf die verschiedenen Tasten und deren unterschiedlichen nachgeschalteten Schaltungen auswirken. Daher ist es bei der genannten kapazitiven Tastatur nach der EP 0 691 743 B1 schwierig, mehrere Tasten mit gleichem Schaltpotential anzuordnen, weil die Kalibrierung dieser Schaltungen sehr schwierig ist.

Diese Kalibrierung stimmt im Übrigen nur für einen einzigen Temperaturwert. Jede Taste hat bei der genannten Schaltung deshalb ein eigenes Temperaturverhalten. Ein Abgleich auf unterschiedliche Umweltbedingungen ist damit nicht möglich. Der Abgleich intern erfolgt bei der Schaltung über ein Potentiometer, wobei dieses Potentiometer jeweils der eigenen Auswerteschaltung zugeordnet ist, die auf jeweils eine kapazitive Taste wirkt.

Mit der EP 0 668 657 B1 ist eine weitere kapazitive Tastatur mit Auswerteschaltung bekannt geworden, bei der ein Frequenzgenerator eine bestimmte Wechselstromamplitude erzeugt, über deren Ermittlung der Schaltpunkt in einem Komparator eingestellt wird. In einem zweiten Zweig liegt die kapazitive Taste, welcher zweite Zweig hochohmig ausgebildet ist. Durch die Wechselspannungsbeschaltung der kapazitiven Taste wird bei Erhöhung der Kapazität dieser Taste (durch Fingerberührung) die Amplitude des Frequenzgenerators in diesem Zweig abgesenkt und damit die Schaltschwelle am Komparator entsprechend unterschritten und es kommt zu einer Auslösung des Schaltvorganges.

Auch bei dieser Anordnung besteht der Nachteil, dass für jede einzelne Taste eine eigene Auswerteschaltung vorhanden ist, so dass diese gesamte Anordnung nur jeweils mit Tasten und zugeordneten, getrennten Auswerteschaltungen arbeitet. Damit können aber Umwelteinflüsse nur ungenügend ausgeglichen werden , weil die Schaltungen und die dazugehörenden Tasten alle einen eigenen Temperaturgang aufweisen.

Wegen der Wechselstrombeaufschlagung sendet diese Schaltung Störstrahlen aus und ist im Übrigen auch störempfindlich durch entsprechende Wechselspannungspotentiale.

Ein Abgleich aller Tasten in einem größeren Temperaturbereich ist aus diesem Grund nicht möglich.

Der Erfindung liegt die Aufgabe zu Grunde eine kapazitive Tastatur mit Auswerteschaltung der eingangs genannten Art so weiterzubilden, dass ein berührungsloses Schalten hinter einem Trägermedium (z. B. Glas, Kunststoff, Keramik oder sonstigen nichtleitenden Materialien) möglich ist und dass die erfindungsgemäße Schaltung Verschmutzungen, Wischvorqänqe oder allgemein versehentliche Vorgänge nicht als Betätigung falsch interpretiert, sondern ausblendet.

Der Erfindung liegt die weitere Aufgabe zugrunde, einen möglichen Temperaturgang zu kompensieren und die gesamte Schaltung unabhängig von Umweltweinflüssen, wie z.B. Feuchtigkeit und Temperaturänderungen zu gestalten.

Zur Lösung der gestellten Aufgabe ist die Erfindung durch die technische Lehre des unabhängigen Patentanspruches gekennzeichnet.

Wesentliches Merkmal der Erfindung ist, dass die jeweilige Taste der kapazitiven Tastatur aus mindestens zwei Kapazitätsflächen besteht, und dass die beiden Kapazitätsflächen variabel aufladbar sind und mit einer Auswerteschaltung die Bestimmung des Entladestroms des, der Schaltbetätigung dienenden, Tastenfeldes erfolgt.

Mit der gegebenen technischen Lehre ergibt sich also der wesentliche Vorteil, dass nun nicht die Entladung oder Aufladung einer einzigen Kapazität am Tastenfeld untersucht wird, sondern dass das Verhalten von mindestens zwei voneinander getrennten Kapazitäten miteinander verglichen wird.

Hierbei bleibt es offen, wie und wo diese Kapazitäten angeordnet sind.

In einer ersten Ausführungsform der Erfindung kann es vorgesehen sein, dass die erfindungsgemäße kapazitive Tastatur lediglich aus einer einzigen Taste besteht, wobei diese Taste lediglich aus einem leitfähigen Material besteht, welches hinter einem Dielektrikum befestigt ist.

Ein derartiges Dielektrikum kann beispielsweise ein Trägermedium sein, wie z. B. Glas, Kunststoff, Keramik oder ein sonstiges, nicht leitendes Material,

Die erwähnten zwei Kapazitäten, die erfindungsgemäß untersucht und ausgewertet werden bestehen bevorzugt aus einer Taste, die beispielsweise ein inneres Tastenfeld bildet, welches an ihrem Außenumfang von einem Isolierring umgeben ist, der wiederum an seinem Außenumfang von einem Referenzring aus einem wiederum leitenden Material ausgebildet ist, welches das gleiche Material sein kann, wie für das innere Tastenfeld verwendet.

Durch die Gegenüberstellung von leitfähigen kapazitiven Belägen bestehend aus dem inneren Tastenfeld und einem davon getrennt und isoliert ausgebildeten äußeren Referenzring werden also die Kapazitätsänderungen dieser beiden Kapazitätsflächen miteinander verglichen und ausgewertet.

Der Begriff Referenzring und Tastenfeld sind nicht einschränkend auf die zu verwendende Geometrie der vorliegenden kapazitiven Tastatur zu verstehen. Diese Tastflächen oder Tastenfelder können in beliebigen geometrischen Anordnungen ausgebildet sein, z.B. kann das innere Tastenfeld rechteckig, oval, rautenförmig oder in jeder beliebigen anderen Formgebung gestaltet werden und es muss nur dafür gesorgt werden, dass der außen liegende ebenfalls aus bevorzugt dem gleichen leitfähigen Material bestehende Referenzring eine etwa gleiche Fläche wie das innere Tastenfeld aufweist. Es ist jedoch nicht notwendig, dass dieser Referenzring die gleiche Formgebung wie das innere Tastenfeld hat. Daher ist es nicht notwendig, dass die beiden kapazitiven Beläge eine konzentrische Anordnung bilden; hierbei ist es z.B. auch möglich, dass der Referenzring außerhalb des Tastenfeldes angeordnet ist und lediglich durch eine Isolierstrecke von diesem getrennt ist.

In einer Weiterbildung der Erfindung ist es vorgesehen, dass auch mehrere Tasten ein kapazitives Tastenfeld bilden, wobei aber dann auf die vorher erwähnte, leitfähige Referenzfläche verzichtet werden kann. Die vorher erwähnte leitfähige Referenzfläche, welche die zweite Kapazität bildet, wird in der zweiten Ausführungsform ersetzt durch die Kapazität der Tastenfelder der übrigen Tasten, die nicht betätigt sind.

Auf diese Weise wird also die Referenzfläche nach dem ersten Ausführungsbeispiel eingespart und eine von der Auswerteschaltung untersuchte Taste mit einem entsprechenden kapazitiven Tastenfeld wird untersucht und mit der Kapazität der übrigen Tastenfelder der übrigen Tasten verglichen.

Mit der gegebenen technischen Lehre ergibt sich also der wesentliche Vorteil, dass ein vollständig berührungsloses Schalten hinter einem Trägermedium stattfinden kann. Daher kann eine derartige kapazitive Tastatur wetterfest und vandalensicher montiert werden, weil für den Schaltvorgang selbst es ausreicht, mit beispielsweise einem Finger oder einem anderen leitfähigen Medium auf die Vorderseite des Trägermediums (Glas, Kunststoff, Keramik oder dergleichen) zu tippen, um die hinter dem Trägermedium angeordneten kapazitiven Beläge zu betätigen.

Es muss also lediglich das Trägermedium berührt werden, während die kapazitiven Beläge selbst nicht berührt werden müssen.

Die Erfindung wird nachfolgend anhand eines Ausführungsbeispieles dargestellt. Hierbei kommt es darauf an, dass mit einfachen Mitteln geringste Kapazitätsänderungen an den vorher erwähnten kapazitiven Belägen möglich sind.

In der Schaltung wird die Ladung Q=I*t eines Kondensators (Pad/Umwelt) ausgewertet.

C=I*t/U >>> I=C*U/t Wenn die Ladung und die Zeit konstant sind, folgt ΔI ≈ ΔC.

Zu diesem Zweck werden Kontaktflächen hinter oder in einem Dielektrikum aufgebracht und kontaktiert. Zum Beispiel Leiterplatten, Silberleitdruck oder aufgedampfte Pads. Gemessen wird die Kapazität zur Umwelt.

Die kleinen Kapazitäten (5....20pF) ergeben bei 1...3V sehr kleine Ladungen. Die Änderungen bei Betätigung sind noch kleiner. Um einen gut messbaren Strom zu erreichen, muss die Zeit (hier Entladezeit) klein sein.

Der dann erreichbare Strom ist immer noch klein und steht nur für eine kurze Zeit zur Verfügung. Als schnelle, preiswerte Entladeverstärkerschaltung hat sich ein Transistor mit Beschaltung ergeben. Der Ausgangsimpuls kann dann auf zwei unterschiedliche Weisen ausgewertet werden.
1. Mit einem Track and Hold, einem Verstärker und A/D-Wandler.
2. Mit einem Komperator.

Beiden Methoden ist gemeinsam, dass die Ladespannung jeder einzelnen Taste statistisch so ausgeregelt wird, dass gerade keine Taste erkannt wird. Das System schwimmt und sucht sich den optimalen Arbeitspunkt.

Die ausgefeilte Software und die Statistik ist ein weiteres notwendiges Standbein für die Funktion.

Beim Anschalten der Tastatur wird ein Kalibrierlauf gestartet, der eine Plausibilitätsprüfung erlaubt. Dies dauert 0,5....2s. Diese Daten werden mit den Produktionsdaten verglichen. Damit erkennt die Tastatur aufgelegte Finger oder nasse Tücher usw.

Über die Statistik aller Tasten werden Temperaturänderungen, Feuchtigkeitsänderungen, Störungen und Änderungen der Umgebung erkannt und ausgeregelt. Mit einem zusätzlichen Temperatursensor können, wenn nötig, die gewonnenen Daten auf Plausibilität überprüft werden.

Durch leichtes Ändern der Ladespannung, Schaltschwelle oder der Entladezeit lässt sich überprüfen, ob eine erkannte Betätigung einem "mit dem Finger berühren" entspricht, oder eine Störung ist. Z.B. wenn bei 15 Messungen eine Betätigung erkannt wird, wird bei der 16. Messung die Ladespannung so verringert, dass keine Taste erkannt werden sollte. Wird trotzdem eine Taste erkannt, werden die Messungen verworfen. Diese Zahlen können beliebig geändert werden und somit die Tastatur den Erfordernissen angepasst werden. Auf diese Weise lässt die Ansprechzeit die Sicherheit einstellen.

Dies ist nicht nur mit mehreren Tasten möglich, sondern dies funktioniert auch mit Einzeltasten. Für die Statistik ist dann ein zweites Ringpad um die eigentliche Tastenfläche notwendig. Damit wird z.B. "das Putzen oder Verschmutzen" erkannt und ausgeregelt.

Bei entsprechender Geometrie sind Dielektrika bis ca. 10 mm (z.B. Glas) möglich und getestet worden. Ebenso ist mit dieser Technik mit aufgedampften Elektroden ein Touchscreen vor z.B. Displays möglich.

Wesentlich bei der Erfindung ist also, dass die Schaltung vollständig gegen Umwelteinflüsse und insbesondere Temperaturen immun ist, weil alle Tasten über ein und die gleiche Auswerteschaltung ausgewertet werden und Fehler sich dadurch kompensieren.

Nach der Erfindung wird in der Schaltung bei jeder einzelnen Taste der Entladestrom erfasst, verstärkt und in einer entsprechenden Auswerteschaltung ausgewertet. Die Auswerteschaltung besteht bevorzugt aus einem Verstärker, einem Integrator und einer entsprechenden statistischen Auswerteschaltung.

Bei dem genannten Sample- und Hold-Baustein handelt es sich um einen entladbaren (rücksetzbaren) Integrator.

In der erfindungsgemäßen Schaltung werden viele einzelne Messungen statistisch ausgewertet. Damit ist es möglich, Betätigungen der kapazitiven Flächen von Störungen zu unterscheiden. Man kann gezielte Kontrollmessungen durchführen, um Ergebnisse zu bestätigen oder zu verwerfen.

Bei Überschreiten einer Schaltschwelle kann ja dieses Überschreiten entweder durch eine Störung oder durch eine beabsichtigte Betätigung des Tastenfeldes erfolgt sein. Wiederholtes Abfragen aller Tastenfelder auf Plausibilität (wurde nur dieses eine Tastenfeld betätigt oder mehrere Tastenfelder?) kann aufgrund dieser Plausibilitätsprüfung dann ausgewertet werden, ob es sich tatsächlich um einen gewollten Schaltvorgang oder um eine ungewollte Störung handelt.

Wichtig ist, dass alle Tasten über die gleiche Schaltung ausgewertet werden, weil sich alle Temperaturänderungen bei allen Tasten gleich auswirken und die Verhältnisse der Tasten zueinander konstant sind. Damit lassen sich Temperaturänderungen leicht ausregeln und über die vorher genannten Plausibilitätsprüfungen eliminieren.

Nach der Erfindung ist also die konsequente Überwachung aller Tasten parallel zueinander möglich, um Störungen auszufiltern, Arbeitspunkte nachzuregeln und gewollte Betätigungen von beispielsweise einem Abwischen aller Tasten zu unterscheiden.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung, offenbarten Angaben und Merkmale, insbesondere die in den Zeichnungen dargestellte räumliche Ausbildung, werden als erfindungswesentlich beansprucht, soweit sie einzeln oder in Kombination gegenüber dem Stand der Technik neu sind.

Im Folgenden wird die Erfindung anhand von mehrere Ausführungswege darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: schematisiert die Betätigung einer Einzeltaste nach der Erfindung;
- Figur 2:: die Draufsicht auf eine Taste nach der Erfindung;
- Figur 3:: eine Auswerteschaltung für die Auswertung eines Schaltvorgangs an der Taste nach Figur 2;
- Figur 4:: eine gegenüber Figur 3 abgewandelte Ausführungsform mit mehreren Tasten;
- Figur 5:: ein Diagramm, in dem auf der Ordinate die Spannung und auf der Abszisse die Zeit aufgetragen ist, um die Schaltvorgänge darzustellen;
- Figur 6:: die Darstellung eines gewollten Schaltvorganges;
- Figur 7:: die Darstellung eines ungewollten Schaltvorganges;
- Figur 8:: das Diagramm nach Figur 5 mit Darstellung der Spannungsverläufe bei ungewollter Betätigung.

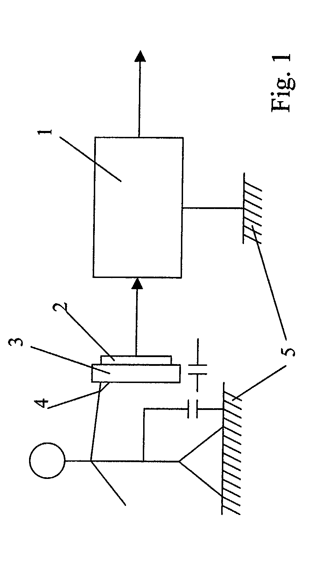

In Figur 1 ist allgemein dargestellt, dass eine beliebige Person mittels der Fingerfläche 4 eine kapazitive Taste betätigen kann, die im gezeigten Ausführungsbeispiel als dielektrische Isolierplatte 3 dargestellt ist, hinter der die erfindungsgemäßen Tastenflächen 2 angeordnet sind. Das Signal der Tastenflächen 2 wird in einer nachgeschalteten Auswerteschaltung 1 ausgewertet.

Wichtig ist, dass die, die Tastenfläche betätigende Person, eine Kapazität gegen Erde bildet, und ebenfalls die Auswerteschaltung 1 auf Masse 5 liegt.

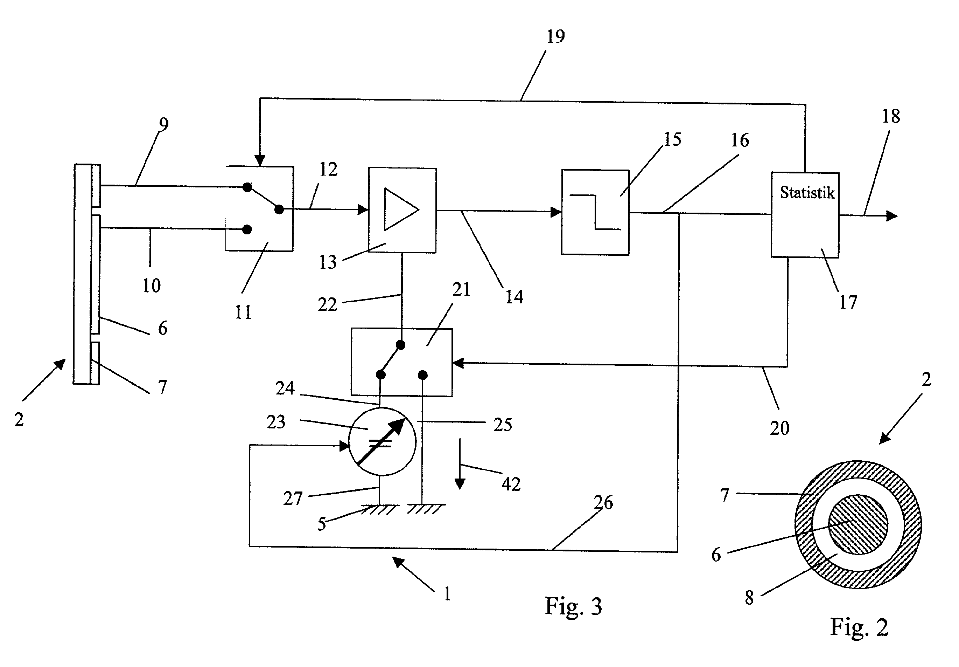

In Figur 2 ist die Draufsicht einer erfindungsgemäßen Taste in runder Ausführung gezeigt.

Hierbei ist das innere Tastenfeld 6 beispielsweise kreisförmig ausgebildet und besteht aus einem leitfähigen Material. Es wird umgeben von einem Isolierring 8, der eine äußere Referenzfläche 7 von dem inneren Tastenfeld 6 trennt.

Die äußere Referenzfläche 7 sollte aus dem gleichen leitfähigen Material wie das innere Tastenfeld 6 bestehen.

Im Übrigen sollten die beiden Flächen des Tastenfeldes 6 und der Referenzfläche 7 etwa gleich groß sein, um eine gleiche Kapazität auszubilden.

Wichtig ist nun, dass bezüglich einer derartigen Tastenfläche 2 zwei Leitungen 9, 10 in den Eingang eines Umschalters 11 münden.

In dem Umschalter 11 wird also ständig zwischen der einen Leitung 9 und der anderen Leitung 10 hin- und hergeschaltet, um also ständig die Kapazitätsänderungen dieser beiden Flächen 6, 7 zu erfassen.

Die Umschaltung des Umschalters 11 erfolgt hier beispielsweise mit einer Frequenz von z.B. 10 - 50 kHz.

Das Ausgangssignal des Umschalters 11 wird über den Ausgang 12 auf den Eingang eines Verstärkers 13 geschaltet, der den am Ausgang 12 anliegenden Lade- oder Entladestrom verstärkt.

Der Ausgang 14 des Verstärkers 13 bildet den Eingang für einen Komparator 15, der in der Regel eine feste Schaltschwelle hat.

Der Ausgang 16 des Komparators wirkt auf einen Statistikbaustein 17, in der die im allgemeinen Beschreibungsteil erwähnte statistische Auswertung der Signale erfolgt.

Je nachdem, welches Programm in der bevorzugt als Mikroprozessor ausgebildeten Statistikbaustein 17 gefahren wird, wird am Ausgang 18 eine Ja/Nein-Entscheidung über das bestimmungsgemäße Schalten der Tastenfläche 2, oder das unerwünschte Signal an der Tastenfläche 2 getroffen.

Wichtig ist, dass die Ansteuerung des Umschalters 11 über eine Leitung 19 als Rückführung von dem Statistikbaustein 17 erfolgt. Auf der Leitung 19 liegen also Digitalsignale dem Statistikbaustein 17, die vom Umschalter 11 mehr Messergebnisse verlangt, wenn das statistische Auswerteprogramm z. B. feststellt, dass zu wenig Messergebnisse für eine eindeutige Aussage vorliegen.

Über die Leitung 19 werden also mehr Messergebnisse vom Umschalter 11 angefordert.

Wichtig ist ferner, dass von der Leitung 16 zwischen dem Komparator 15 und dem Statistikbaustein 17 eine Leitung 26 abzweigt, die den Regelzweig für eine regelbare Gleichstromquelle 23 bildet.

Am Bezugspunkt des Verstärkers (Leitung 22) liegt nämlich ein weiterer Umschalter 21, der das Laden und Entladen der kapazitiven Flächen 6, 7 gegen Masse 5 ausführt.

Zu diesem Zweck wird der Umschalter durch die rückgeführte Leitung 20 auch von dem Statistikbaustein 17 angesteuert.

Er schaltet deshalb entweder auf die Leitung 24, welche den Eingang für die regelbare Gleichstromquelle 23 bildet und über die Leitung 27 zur Masse liegt oder wahlweise auch auf die Leitung 25, die unmittelbar auf die Masse einen Entladestrom 42 ableitet.

Zur Kalibrierung wird zunächst der Statistikbaustein 17 über die Leitungen 19, 20 die entsprechenden Umschalter 11, 21 ansteuern und eine erste Serie von Messergebnissen anfordern.

Es erfolgt hierdurch eine Einregelung auf einen stabilen Arbeitspunkt. Dieser stabile Arbeitspunkt wird nun in Abhängigkeit von entsprechenden Verschmutzungen dieser Tastatur, von Temperatureinflüssen, von Feuchtigkeitseinflüssen und dergleichen bestimmt.

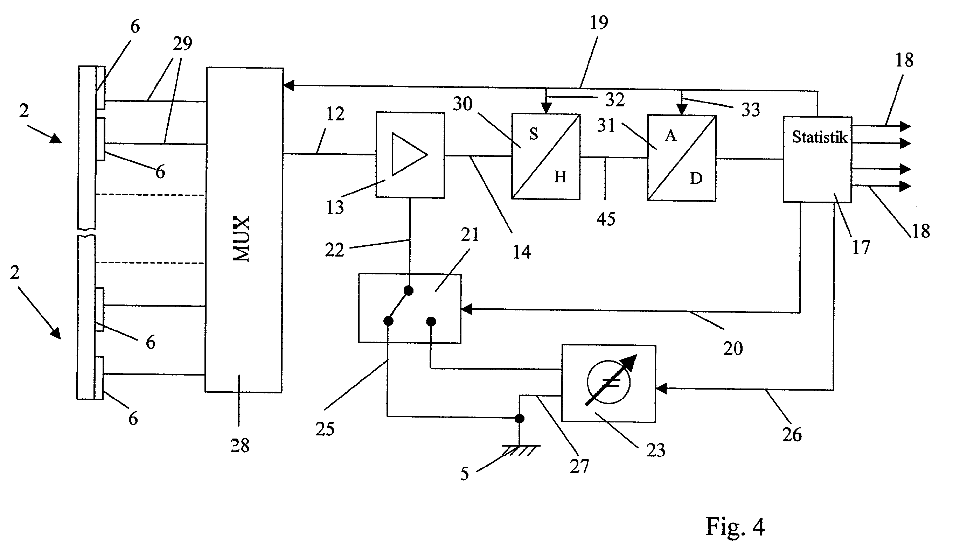

Hier liegt der wesentliche Vorteil der Erfindung, weil - wie anhand der Figur 4 noch zu zeigen sein wird - alle Tasten an ein und der gleichen Auswerteschaltung anliegen.

Es wird also der Arbeitspunkt für die Referenzfläche 7 und der Arbeitspunkt für das innere Tastenfeld 6 bestimmt.

Verschieben sich deren Verhältnisse zueinander, kann man evtl. daraus ableiten, dass eine beabsichtigte Betätigung der Tastenfläche 2 stattgefunden hat. Verschieben sich jedoch die Verhältnisse zwischen den Tastenflächen 6, 7 parallel zueinander, kann davon abgeleitet werden, dass eine unbeabsichtigte Betätigung der Tastenfläche 2 (z.B. durch Abwischen mit einem Tuch) stattgefunden hat, die nicht zu einem Auslösen des Schaltvorganges am Ausgang 18 führen soll.

In Figur 4 ist ein Tastenfeld bestehend aus mehreren Tastenflächen 2 dargestellt.

Hierbei ist wesentlich, dass keine Referenzflächen 7 mehr vorhanden sind, sondern dass diese Referenzflächen 7 durch die anderen Tastenfelder 6 der anderen, im Augenblick nicht abgefragten Tasten gebildet wird.

Alle Tastenfelder 6 sind also über Leitungen 29 mit dem Eingang eines Multiplexers 28 verbunden, der zyklisch alle Tastenfelder 6 abfragt. Die Abfrage erfolgt beispielsweise mit einer Frequenz von 5 - 500 kHz.
Der Ausgang 12 des Multiplexers bildet den Eingang für den Verstärker 13, dessen Ausgang 14 den Eingang für einen Integrator 30 bildet.

Dieser Integrator 30 ist rücksetzbar, das heißt, er kann durch bestimmte Schaltungsmaßnahmen immer wiederholt in seinen Ausgangszustand 0 gebracht werden.

Der Ausgang des Intergrators 30 liegt über eine Leitung 45 an einem A/D-Wandler 31 an, der das Signal mit der gleichen Frequenz wie der Multiplexer 28 abtastet, das heißt die beiden arbeiten synchron.

Es wird demzufolge das einzelne Potential jeder einzelnen Taste ermittelt und dem Statistikbaustein 17 zugeführt.

Dieser Statistikbaustein 17 kann über eine Vielzahl von Ausgängen 18 verfügen, nämlich so viele Ausgänge wie beispielsweise Tastenflächen 2 vorhanden sind.

Es kann auch eine serielle Schnittstelle vorhanden sein, oder eine parallele Schnittstelle.

Über die Leitung 20 wird der Umschalter 21 angesteuert, während über die Leitung 26 wiederum die regelbare Gleichstromquelle 23 angesteuert wird. Von der Leitung 19 folgen noch die Leitungen 32, 33 ab, welche die entsprechenden Bausteine 30 und 31 takten.

Vorteil der Schaltung nach Figur 4 ist also ein Tastenfeld, bei dem wichtig ist, dass alle Tastenflächen lediglich mit einer einzigen Auswerteschaltung ausgebildet werden.

Es gelten im Übrigen für diese Schaltungsteile die gleichen Erläuterungen wie sie anhand der Figur 3 gegeben wurden.

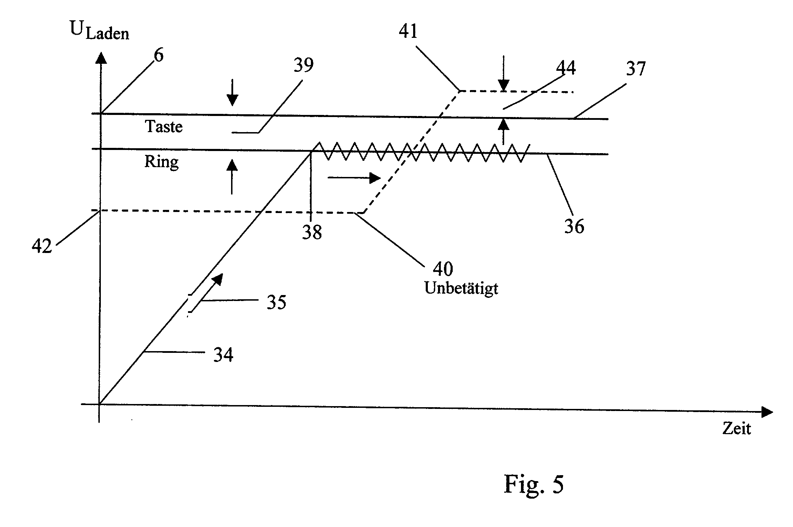

In Figur 5 ist ein Schaltdiagramm dargestellt, wobei auf der Ordinate ein Spannung abgebildet ist, während auf der Abszisse die Zeit dargestellt ist.

Es wird zunächst bezüglich des Tastenfeldes 6 eine Schaltschwelle 37 definiert, deren Potential geringfügig höher ist als die Schaltschwelle 36 der Referenzfläche 7.

Zwischen beiden Schaltschwellen 36, 37 kann also ein Schaltabstand 39 definiert werden.

Von einem Startzeitpunkt aus (zum Beispiel Einschalten der Schaltung) wird nun eine Ladespannung 34 an jeweils einer Kapazität 6, 7 erzeugt. Das Aufladen erfolgt sehr schnell in Pfeilrichtung 35, so lange, bis bei Position 38 eine Regelung um die Schaltschwelle 36 der Referenzfläche 7 stattfindet. Wichtig ist also, dass das Potential des Tastenfeldes 6 auf die Schaltschwelle der Referenzfläche 7 hochgeregelt wird.

Im Ruhezustand, das heißt also im unbetätigten Zustand ist daher der Entladestrom 42 des Tastenfeldes 6 unterhalb dieser Schaltschwelle 36 angeordnet. Dies entspricht der gestrichelten Linie in Figur 5.

Wird hingegen bei Position 40 das Tastenfeld 6 betätigt, erfolgt ein Anstieg der Kapazität bis zur Position 41, das heißt, der Entladestrom überschreitet die Schaltschwelle 37 des Tastenfeldes 6 um den Schaltabstand 44, wodurch es zu einer gewollten Schaltung kommt. Das hierdurch erzeugte Signal wird nun statistisch in dem Statistikbaustein 17 ausgewertet.

Kommt es zu mehreren Schaltvorgängen in kurzer Zeit hintereinander und bleibt die Schaltschwelle 36 der Referenzfläche unverschoben, dann lässt dies auf eine gewollte Betätigung der Tastenfläche 2 schließen.

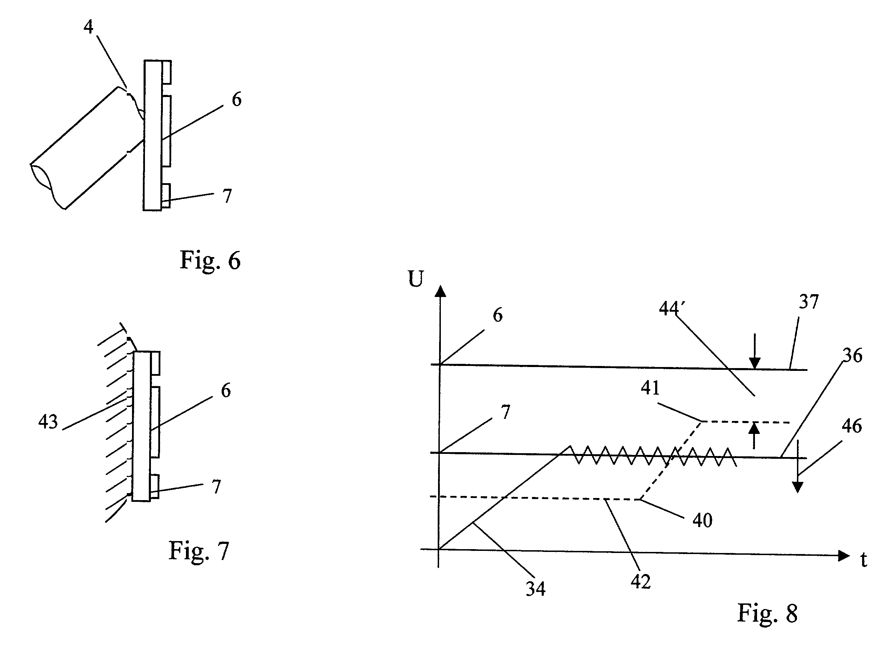

Dies ist beispielsweise in Figur 6 dargestellt, wo mit einer Fingerfläche 4 lediglich die Kapazität im Bereich des Tastenfeldes 6 beeinflusst wird, während die Kapazität im Bereich der umliegenden Referenzfläche 7 davon unbeeinflusst ist. Mit dieser Betätigung ergibt sich also ein Schaltvorgang gemäß Figur 5.

Erfolgt hingegen die Überdeckung der Tastenfläche 2 mit einer großflächigen Falschfläche 43, dann wird die Kapazität sowohl der Referenzfläche 7 als auch des Tastenfeldes 6 angehoben. Hierdurch ergibt sich die Situation nach Figur 8.

Wenn also eine große Kapazität vorhanden ist, kann mit einer geringen Spannung diese Kapazität aufgeladen werden, so dass die Schaltschwelle 36 bereits schon in Pfeilrichtung 46 absinkt.

Es wird demzufolge auch das Potential des Tastenfeldes 6 auf einen geringeren Wert aufgeladen, so wie dies mit der Ladespannung 34 angegeben ist.

Ferner ist aufgrund der gemeinsamen Betätigung dieser beiden Flächen auch der Entladestrom verringert, so dass bei einer Betätigung durch eine großflächige Falschfläche 43 lediglich von Position 40 auf Position 41 der Entladestrom angehoben wird, aber diese Schwelle bei Position 41 nicht ausreicht, die Schaltschwelle 37 zu überschreiten.

Es kommt damit zu einem negativen Schaltabstand 44 -, das heißt, um diesen Betrag wird eine Auslösung verhindert. Es kommt daher nicht zu einem Signal am Ausgang der statistischen Auswerteschaltung.

Die Vorteile der Erfindung liegen gerade im Erkennen einer Falschbetätigung. Beispielsweise kann die Bedeckung der Tastenfläche mit Wasser, mit Verunreinigungen wie zum Beispiel Ketch-Up und dergleichen einwandfrei erkannt werden. Dies erhöht die Aussagesicherheit der Taste und daher können die erfindungsgemäßen kapazitiven Tastaturen auch für hochempfindliche medizinische Geräte eingesetzt werden.

Die gesamte Schaltung ist im Übrigen relativ unempfindlich gegen Störeinflüsse, weil eine statistische Auswertung der Schaltergebnisse erfolgt und Wechselspannung in der Schaltung vermieden werden.

Die Erfindung betrifft also eine kapazitive Tastatur mit mindestens einer Auswerteschaltung, beinhaltend mindestens eine kapazitive Tastenfläche, welche mit der mindestens einen Auswerteschaltung elektrisch leitend verbunden ist und welche mindestens eine kapazitive Tastenfläche auf und/oder in einer Isolierplatte angeordnet ist, und welche mindestens eine kapazitive Tastenfläche durch Annäherung und/oder Berührung eines beweglichen Dielektrikums seine Kapazität verändert, welche Kapazitätsänderung in der Auswerteschaltung auswertbar ist, wobei die mindestens eine Tastenfläche mindestens zwei, voneinander elektrisch isolierte und elektrisch auf- und entladbare Kapazitätsflächen beinhaltet und deren jeweilige Ent- und/oder Aufladeströme durch die mindestens eine Auswerteschaltung derart ausgewertet werden können, dass mindestens zwischen einem Ruhezustand und einem beabsichtigten Schaltzustand der Tastenfläche unterschieden werden kann, wobei die mit den jeweiligen Kapazitätsflächen zusammenwirkenden Kapazitätsflächen des jeweiligen kapazitiven Schalters über das angenäherte und/oder kontaktierte bewegliche Dielektrikum mit der Auswerteschaltung elektrisch leitend verbunden ist.

Vorteil hierbei ist, dass nicht die Entladung oder Aufladung einer einzigen Kapazität am Tastenfeld untersucht wird, sondern dass das Verhalten von mindestens zwei voneinander elektrisch isolierten Kapazitäten miteinander verglichen wird, wobei es offen bleibt, wie und wo diese Kapazitäten angeordnet sind.

Hierdurch können gewollte Schaltvorgänge von unbeabsichtigten Schaltvorgängen und von Verschmutzungen etc. sicher unterschieden werden.

### Zeichnungslegende

- 1: Auswerteschaltung
- 2: Tastenfläche
- 3: Isolierplatte (dielektrisch)
- 4: Fingerfläche
- 5: Masse
- 6: Tastenfeld (innen)
- 7: Referenzfläche
- 8: Isolierung
- 9: Leitung
- 10: Leitung
- 11: Umschalter
- 12: Ausgang
- 13: Verstärker (Impulsstrom)
- 14: Ausgang
- 15: Komparator
- 16: Ausgang
- 17: Statistikbaustein
- 18: Ausgang
- 19: Leitung
- 20: Leitung
- 21: Umschalter
- 22: Leitung
- 23: Gleichstromquelle
- 24: Leitung
- 25: Leitung
- 26: Leitung
- 27: Leitung
- 28: Multiplexer
- 29: Leitung
- 30: Integrator
- 31: A/D-Wandler
- 32: Leitung
- 33: Leitung
- 34: Ladespannung (7)
- 35: Pfeilrichtung
- 36: Schaltschwelle (7)
- 37: Schaltschwelle (6)
- 38: Position
- 39: Schaltabstand
- 40: Position (unbetätigt)
- 41: Position (betätigt)
- 42: Entladestrom (6)
- 43: Falschfläche
- 44: Schaltabstand 44'
- 45: Leitung
- 46: Pfeilrichtung

## Patentansprüche

1. Kapazitive Tastatur mit mindestens einer Auswerteschaltung (1), beinhaltend mindestens eine kapazitive Tastenfläche (2), welche mit der mindestens einen Auswerteschaltung (1) elektrisch leitend verbunden ist und welche mindestens eine kapazitive Tastenfläche (2) auf und/oder in einer Isolierplatte (3) angeordnet ist, und welche mindestens eine kapazitive Tastenfläche (2) durch Annäherung und/oder Berührung eines beweglichen Dielektrikums (4) seine Kapazität verändert, welche Kapazitätsänderung in der mindestens einen Auswerteschaltung (1) auswertbar ist, **dadurch gekennzeichnet, dass** die mindestens eine Tastenfläche (2) mindestens zwei, voneinander elektrisch isolierte und elektrisch auf- und entladbare Kapazitätsflächen (6; 7) beinhaltet, deren entgegengesetzten, mit diesen zusammenwirkenden Kapazitätsflächen über das angenäherte und/oder kontaktierte bewegliche Dielektrikum (4) mit der Auswerteschaltung (1) elektrisch leitend verbunden sind und deren jeweilige Ent- und/oder Aufladeströme durch die mindestens eine Auswerteschaltung (1) derart ausgewertet werden können, dass mindestens zwischen einem Ruhezustand, einem beabsichtigten Schaltzustand und einem unbeabsichtigten, fehlerhaften Schaltzustand der mindestens einen Tastenfläche (2) unterschieden werden kann.

2. Kapazitive Tastatur nach Anspruch 1, **dadurch gekennzeichnet, dass** die elektrisch leitende Verbindung des angenäherten und/oder kontaktierten beweglichen Dielektrikums (4) mit der Auswerteschaltung (1) über eine jeweilige Erdung erfolgt.

3. Kapazitive Tastatur nach einem der Ansprüche 1 oder 2, **dadurch gekennzeichnet, dass** das angenäherte und/oder kontaktierte bewegliche Dielektrikum (4) eine Fingerfläche einer Bedienperson darstellt.

4. Kapazitive Tastatur nach einem der Ansprüche 1 bis 3, **dadurch gekennzeichnet, dass** bei Vorsehen mehrerer kapazitiver Tastenflächen (2) im Wesentlichen alle mit einer einzigen Auswerteschaltung (1) elektrisch leitend verbunden sind und ausgewertet werden können.

5. Kapazitive Tastatur nach einem der Ansprüche 1 bis 4, **dadurch gekennzeichnet, dass** die Kapazitätsflächen (6; 7) in der Isolierplatte (3) angeordnet sind und/oder hinter dieser, also dem angenäherten und/oder kontaktierten beweglichen Dielektrikum (4) bzw. dem Benutzer abgewandt, so dass keine direkte Berührung der Kapazitätsflächen (6; 7) durch das angenäherte und/oder kontaktierte bewegliche Dielektrikum (4) bzw. den Benutzer erfolgt.

6. Kapazitive Tastatur nach einem der Ansprüche 1 bis 5, **dadurch gekennzeichnet, dass** die Kapazitätsflächen (6; 7) beliebig variabel mit elektrischer Ladung (Q) zwischen einem Maximalwert und einem Minimalwert auf- und entladbar sind.

7. Kapazitive Tastatur nach einem der Ansprüche 1 bis 6, **dadurch gekennzeichnet, dass** die Isolierplatte (3) Glas und/oder Kunststoff und/oder Keramik beinhaltet oder daraus besteht.

8. Kapazitive Tastatur nach einem der Ansprüche 1 bis 7, **dadurch gekennzeichnet, dass** mindestens eine Kapazitätsfläche (7) der mindestens zwei Kapazitätsflächen (6; 7) mindestens eine andere Kapazitätsfläche (6) mindestens teilweise umgibt, jedoch über eine Isolierfläche (8) zu dieser elektrisch isoliert ist.

9. Kapazitive Tastatur nach Anspruch 8, **dadurch gekennzeichnet, dass** die mindestens eine umgebende Kapazitätsfläche (7) etwa kreisringförmig ausgebildet ist und die mindestens eine umfasste Kapazitätsfläche (6) etwa kreisförmig ausgebildet ist.

10. Kapazitive Tastatur nach einem der Ansprüche 1 bis 7, **dadurch gekennzeichnet, dass** mindestens eine Kapazitätsfläche (7) der mindestens zwei Kapazitätsflächen (6; 7) räumlich getrennt von der mindestens einen anderen Kapazitätsfläche (6) ausgebildet ist, und über eine Isolierfläche (8) zu dieser elektrisch isoliert ist.

11. Kapazitive Tastatur nach einem der Ansprüche 1 bis 10, **dadurch gekennzeichnet, dass** die Kapazitätsflächen (6; 7) einer jeweiligen Tastenfläche (2) etwa gleiche Flächen besitzen.

12. Kapazitive Tastatur nach einem der Ansprüche 1 bis 11, **dadurch gekennzeichnet, dass** bei Vorsehen mehrerer kapazitiver Tastenflächen (2) im Wesentlichen alle Kapazitätsflächen (6; 7) aller Tastenflächen (2) etwa gleiche Flächen besitzen.

13. Kapazitive Tastatur nach einem der Ansprüche 1 bis 12, **dadurch gekennzeichnet, dass** die Entladeströme und/oder Aufladeströme der Kapazitätsflächen (6; 7) ständig getaktet durch die mindestens eine Auswerteschaltung (1) ausgewertet werden.

14. Kapazitive Tastatur nach einem der Ansprüche 1 bis 13, **dadurch gekennzeichnet, dass** die Auswerteschaltung (1) zwischen den jeweiligen Kapazitätsflächen (6,6 oder 6,7) über mindestens einen Umschalter (11) getaktet umschaltet.

15. Kapazitive Tastatur nach einem der Ansprüche 1 bis 14, **dadurch gekennzeichnet, dass** die Auswerteschaltung (1) bei Vorsehen mehrerer kapazitiver Tastenflächen (2) zwischen diesen über mindestens einen Umschalter (28) getaktet umschaltet.

16. Kapazitive Tastatur nach Anspruch 15, **dadurch gekennzeichnet, dass** der Umschalter (28) ein Multiplex-Baustein ist.

17. Kapazitive Tastatur nach einem der Ansprüche 1 bis 16, **dadurch gekennzeichnet, dass** die Auswerteschaltung (1) einen Verstärker (13), einen Statistikbaustein (17), eine Gleichstromquelle (23) beinhaltet, sowie entweder einen Track and Hold-Baustein bzw. Integrator (30) und einen A/D-Wandler (31) oder aber einen Komparator (15).

18. Kapazitive Tastatur nach einem der Ansprüche 1 bis 17, **dadurch gekennzeichnet, dass** der Verstärker (13) über einen weiteren Umschalter (21) mit der Gleichstromquelle (23) verbunden ist.

19. Kapazitive Tastatur nach Anspruch 18, **dadurch gekennzeichnet, dass** die Gleichstromquelle (23) und/oder der Umschalter (21) über Masse (5) auf Erdpotential liegt.

20. Kapazitive Tastatur nach einem der Ansprüche 17 bis 19, **dadurch gekennzeichnet, dass** der Statistikbaustein (17) und/oder der Track and Hold-Baustein bzw. Integrator (30) und der A/D-Wandler (31) mit dem Umschalter (11; 28) synchronisiert sind.

21. Kapazitive Tastatur nach einem der Ansprüche 18 bis 20, **dadurch gekennzeichnet, dass** der Umschalter (11; 28) am Ausgang der Tastenfläche (2) mit dem Umschalter (21) zwischen Verstärker (13) und Gleichstromquelle (23) synchronisiert ist.

22. Kapazitive Tastatur nach einem der Ansprüche 17 bis 21, **dadurch gekennzeichnet, dass** der Statistikbaustein (17) einen oder mehrere Ausgänge (18) besitzt.

23. Kapazitive Tastatur nach einem der Ansprüche 1 bis 22, **dadurch gekennzeichnet, dass** der mindestens der Ruhezustand und/oder ein Schaltzustand der kapazitiven Tastenfläche (2) optisch angezeigt wird.

24. Kapazitive Tastatur nach Anspruch 23, **dadurch gekennzeichnet, dass** die optische Anzeige über LED erfolgt.
